# EUROPEAN PATENT SPECIFICATION

(11) **EP 1 610 427 B1**
(45) Date of publication and mention of the grant of the patent: **16.07.2008**
(21) Application number: 04722669.1
(22) Date of filing: 23.03.2004
(51) Int. Cl.: H01S 5/18

(54) **TWO-DIMENSIONAL PHOTONIC CRYSTAL SURFACE-EMITTING LASER**
ZWEIDIMENSIONALER, OBERFLÄCHENEMITTIERENDER LASER MIT PHOTONISCHEM KRISTALL
LASER A EMISSION DE SURFACE A CRISTAL PHOTONIQUE A DEUX DIMENSIONS

(30) Priority: 25.03.2003 JP 2003083706
(43) Date of publication of application: 28.12.2005
(73) Proprietor: Japan Science and Technology Agency, Kawaguchi-shi, Saitama 332-0012 (JP)
(72) Inventor: Noda, Susumu, Uji-shi, Kyoto 6110011 (JP); Yokoyama, Mitsuru Konica Minolta Technology Center Inc., Hino-shi, Tokyo 1918511 (JP); Sekine, Koujirou Konica Minolta Technology Center Inc., Hino-shi, Tokyo 191- 8511 (JP); Miyai, Eiji, Kyoto-shi, Kyoto 6158123 (JP)
(74) Representative: Schoppe, Fritz
(86) International application number: PCT/JP2004/003987
(87) International publication number: WO 2004/086575

(56) References cited:
- EP-A- 1 411 603
- JP-A- 2000 332 351
- JP-A- 2003 023 193
- US-A- 5 617 445
- YOKOYAMA M ET AL: "Two-dimensional photonic crystal lasers" PROCEEDINGS OF THE SPIE - THE INTERNATIONAL SOCIETY FOR OPTICAL ENGINEERING SPIE-INT. SOC. OPT. ENG USA, vol. 4651, 2002, pages 222-232, XP002396940 ISSN: 0277-786X
- PAINTER O. ET AL.: 'Two-dimensional photonic band-gap defect mode laser' SCIENCE vol. 284, no. 5421, 11 June 1999, pages 1819 - 1821, XP002960722
- NODA S. ET AL.: 'Polarization mode control of two-dimensional photonic crystal laser by unit cell structure design' SCIENCE vol. 293, no. 5532, 10 August 2001, pages 1123 - 1125, XP002960723
- YOKOYAMA HIKARU, NODA SUSUMU: 'Dai 3 bunsatsu' DAI 64 KAI EXTENDED ABSTRACTS; THE JAPAN SOCIETY OF APPLIED PHYSICS GAKUJUTSU KOENKAI KOEN YOKOSHU 2003, page 935, XP002982560

## Description

### [Technical Field]

The present invention relates to a two-dimensional photonic crystal surface-emitting laser, and more particularly to a two-dimensional photonic crystal surface-emitting laser having a photonic crystal periodic structure with a two-dimensionally periodic refractive index distribution in or near an active layer which emits light when carriers are injected thereto.

### [Background Art]

Conventionally, lasers of a surface-emitting type which emits laser beams from a surface of the substrate in a direction perpendicular to the surface have been studied and developed into various kinds. Such a surface-emitting laser contains a large number of elements arrayed in one substrate and is capable of emitting parallel coherent light from the respective elements. Therefore, such surface-emitting lasers are expected to be used in the fields of parallel light pick-up, parallel light transmission and optical parallel information processing.

For example, Japanese Patent Laid-Open Publication No. 2000-332351 discloses a two-dimensional photonic crystal surface-emitting laser using a photonic crystal. The photonic crystal is a crystal with a refractive index period which is substantially equal to or smaller than the wavelength of light. By the law that in a multidimensional periodic structure of a dielectric, a band gap occurs in ions in a conductor crystal, in a photonic crystal, a band which inhibits radiation of light (photonic band gap) occurs, and thereby, it is possible to confine light two-dimensionally or three-dimensionally.

The two-dimensional photonic crystal surface-emitting laser disclosed by Japanese Patent Laid-Open Publication No. 2000-332351 has a photonic crystal periodic structure with a two-dimensionally periodic refractive index distribution near an active layer which emits light when carriers are injected thereto. Light resonates in the photonic crystal, and thereby, the laser emits light from a surface.

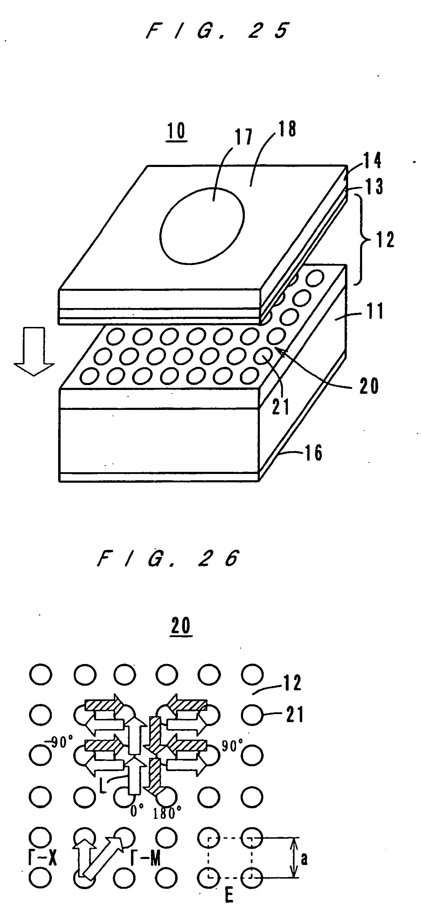

More specifically, as Fig. 25 shows, the two-dimensional photonic crystal surface-emitting laser 10 generally has a lower clad layer 12, an active layer 13 and an upper clad layer 14 stacked one upon another on a substrate 11, and in the lower clad layer 12, a two-dimensional photonic crystal 20 is provided near the active layer 13.

The substrate 11 is, for example, made of a semiconductor material such as n-type InP. The lower clad layer 12 and the upper clad layer 14 are semiconductor layers made of, for example, n-type InP and p-type InP, respectively, and the refractive indices of the clad layers 12 and 14 are lower than that of the active layer 13. The two-dimensional photonic crystal 20 has hollow holes made in the lower clad layer 12. Thereby, a photonic crystal periodic structure 21 composed of the hollow holes is formed. The hollow holes are arrayed into a square lattice or a triangular lattice so that a medium with a refractive index different from that of the lower clad layer 12 is scattered in the lower clad layer 12 with two-dimensional periodicity. In the hollow holes, a material such as SiN or the like may be filled. The active layer 13 is, for example, of a multiple quantum well structure of a semiconductor material such as InGaAs/InGaAsP, and when carriers are injected into the active layer 13, the active layer 13 emits light.

The active layer 13 is located between the lower clad layer 12 and the upper clad layer 14, so that a double heterojunction is formed, and in this structure, the carriers, which contribute to light emission, gather in the active layer 13.

A lower electrode 16 and an upper electrode 17 are formed of gold or the like on the lower surface of the substrate 11 and on the upper surface of the upper clad layer 14, respectively. When voltages are applied to the electrodes 16 and 17, the active layer 13 emits light, and a component leaking from the active layer 13 enters the two-dimensional photonic crystal 20. Light with a wavelength coincident with the intervals among the lattice points (hollow holes) is resonated and amplified by the two-dimensional photonic crystal 20. Thereby, coherent light is surface-emitted from the upper surface (an emitting area 18 around the electrode 17) of the upper clad layer 14.

Now referring to Fig. 26, the function of the two-dimensional photonic crystal 20 as a resonator is described. In the case of Fig. 26, the two-dimensional photonic crystal 20 is a square lattice. However, the shape of the lattice may be rectangular or of other shapes as well as square.

The two-dimensional photonic crystal 20 is a square lattice wherein lattice points of a second medium 21, such as hollow holes, are placed in the first medium 12 at uniform intervals in two orthogonal directions, the intervals in one direction and the intervals in the other direction being equal to each other. The square lattice has representative directions, namely, Γ-X direction and Γ-M direction. If the intervals among the lattice points of the second medium 21 in the Γ-X direction are a, a fundamental lattice E composed of the lattice points of the second medium 21 is a square with four sides having a length of a.

When light L with a wavelength X coincident with the lattice interval a travels in the Γ-X direction, the light L is diffracted on the lattice points. Of the light L, only the components diffracted in directions at 0 degree, ± 90 degrees and 180 degrees to the traveling direction fulfill the Bragg condition. Then, since lattice points exist also in the traveling directions of the components diffracted at 0 degree, ± 90 degrees and 180 degrees, the components are diffracted again on the lattice points in directions at 0 degree, ± 90 degrees and 180 degrees to the respective traveling directions.

When the diffraction of the light L is performed once or repeated a plurality of times, the diffracted light returns to the initial lattice point, which causes resonance. Also, the component diffracted in the direction perpendicular to the surface of the paper of Fig. 26 fulfills the Bragg condition. The light amplified by the resonance is effused through the upper clad layer 14, and in this way, the two-dimensional photonic crystal laser 10 performs surface emission. The above-described phenomenon occurs on all the lattice points, which permits oscillation of a coherent laser all over the surface.

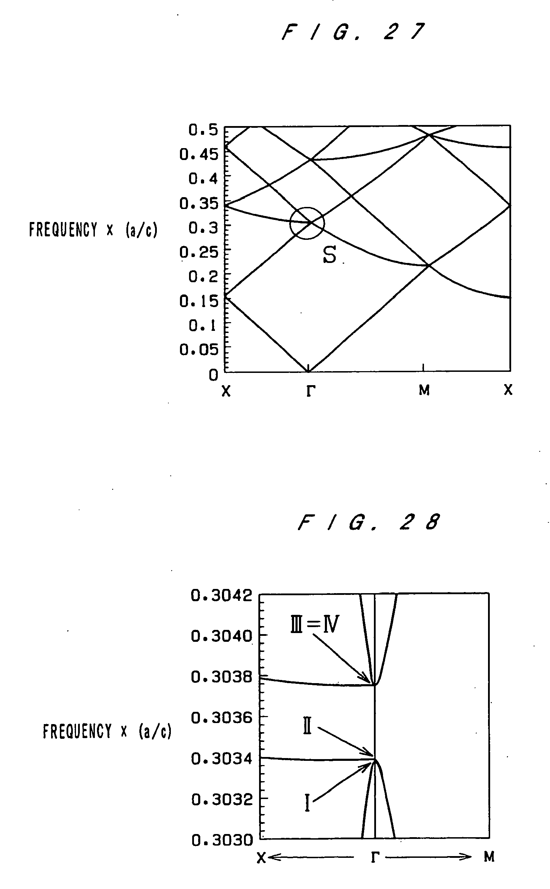

In order to study the two-dimensional resonance phenomenon by use of a photonic crystal more quantitatively, the dispersion relation of light in the two-dimensional square lattice photonic crystal is shown by Fig. 27. In Fig. 27, the axis of abscissa shows the wave number vector indicating the wave number and the direction of light. The axis of ordinate shows the normalized non-dimensional frequency which was obtained by multiplying the light frequency with a/c, in which c is the light velocity (m/sec), and a is the lattice interval (m).

Since the group velocity vg, which is the propagation velocity of light energy, is expressed by ∂ω/∂k, at a band edge where the gradient in the graph of Fig. 27 is 0, the group velocity of light is 0, which means that a standing wave occurs. Therefore, at various band edges, distinctive laser oscillations in accordance with the respective band edges are possible. Especially, the band edge denoted by S (Γ point in the second group) in Fig. 27 is an oscillation point where binding of the above-described four waves and pick-up of light in a direction perpendicular to the surface are possible.

Fig. 28 shows the details of the part S. Referring to Fig. 28, there are four band ends (modes) I, II, III and IV on the point Γ, and the band ends III and IV are double-degenerate. Laser oscillation occurs at one of these four band ends (modes).

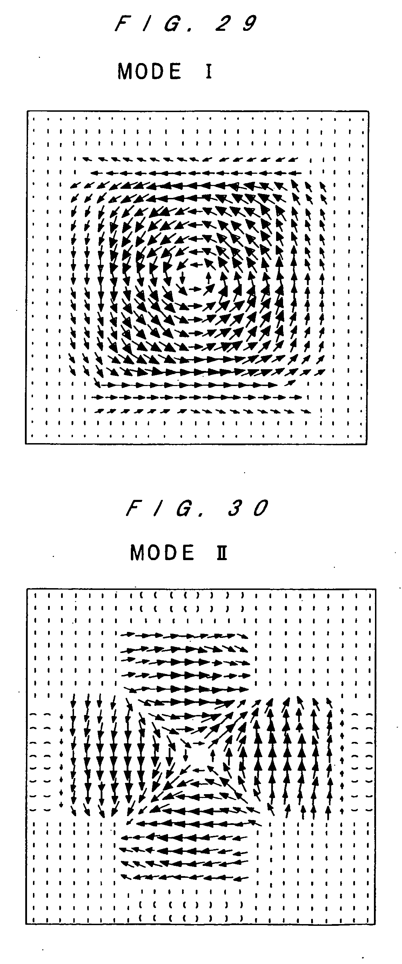

Because the two band ends III and IV of these four modes are degenerate, the electric field distribution depends on the characteristics of the degeneration and therefore is not definite and is unstable. In the other non-degenerate two modes I and II, the polarization is peculiar as shown by Figs. 29 and 30. Fig. 29 shows the electric field distribution of the surface emission component in the mode I. Fig. 30 shows the electric field distribution of the surface emission component in the mode II.

As is apparent from Figs. 29 and 30, in both the mode I and the mode II, the direction of polarization varies from area to area. Therefore, it is impossible to use this laser for a device which requires uniform polarization. Additionally, in this laser, in the center of the emitting surface, electric fields overlap to offset each other, resulting in surface emission of a donut shape having a bright peripheral area and a dark center.

In the double-degenerate modes III and IV, the electric field distribution is not definite as mentioned above, and therefore, the polarization in the modes III and IV is unstable. In view of this problem existing in the prior art, the present inventors had tried to achieve polarization in a uniform direction, and as disclosed by Japanese Patent Laid-Open Publication No. 2003-23193, they found that polarization in a uniform direction can be achieved by designing the shapes of the lattice points of the two-dimensional photonic crystal appropriately.

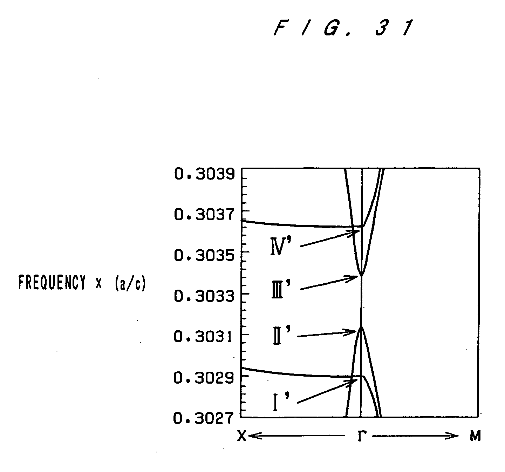

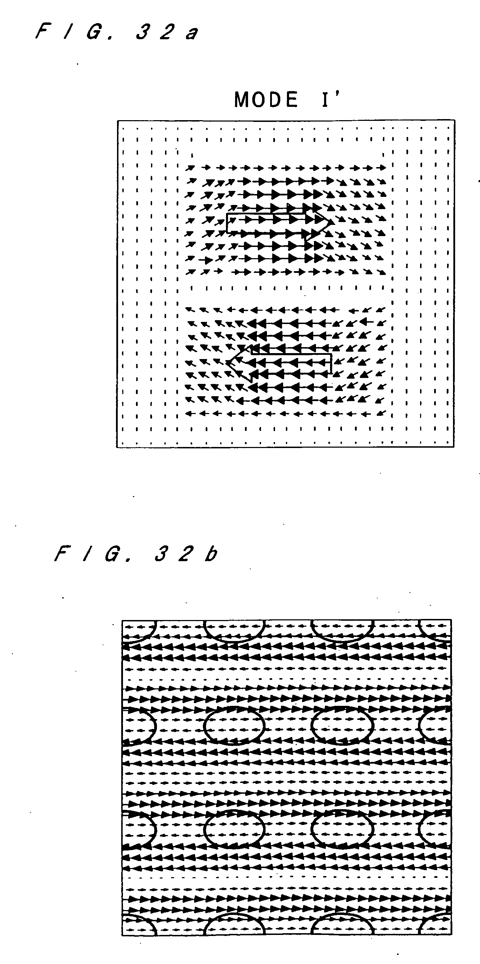

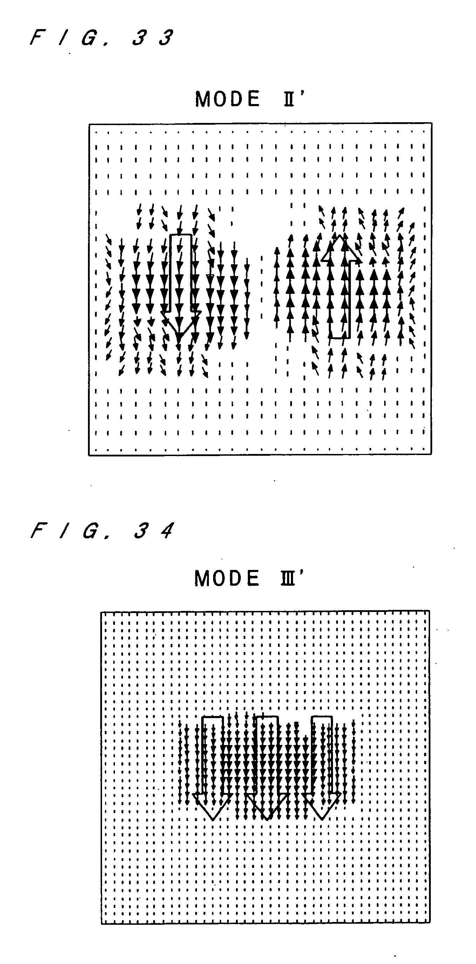

As an example, Fig. 31 shows the band structure around the oscillation point when the lattice points are elliptic. Figs. 32a through 35b show the electric field distribution.

Referring to Fig. 31, the degenerate modes III and IV, which exist when the lattice points are circular, are not seen, and instead, there are non-generate modes III' and IV'. Here, in order to distinguish the modes obtained by the elliptic lattice points from the modes obtained by the circular lattice points, the modes obtained by the elliptic lattice points are referred to as mode I', mode II', mode III' and mode IV' in sequence from the one with the lowest energy.

As is apparent from Figs. 32a through 35b, the most important advantage of designing the lattice points to be elliptic is that not only in the non-degenerate modes III' and IV' but also in the modes I' and II', the direction of polarization is uniform.

In the modes III' and IV', in the entire emitting surface, the polarization is uniform in phase as well as in direction. In the modes I' and II', however, although the direction of polarization is uniform, the phase is opposite (rotates at 180 degrees) between the upper area and the lower area (in the mode I') or between the right area and the left area (in the mode II'). Therefore, in the modes I' and II', electric fields offset each other in the center of the emitting surface, and two-lobed emission occurs, resulting in a dark center area.

Further, because the photonic crystal has a characteristic as a resonator, the modes I' and II' have higher Q-values than the modes III' and IV'. Therefore, in a case of selecting the modes III' and IV' as oscillation modes, the threshold is higher compared with a case of selecting the modes I' and II' as an oscillation mode. Thus, it is difficult to achieve the both merits, namely, single-lobed linear polarization and a low threshold (a high Q-value).

### [Summary of the Invention]

It is an object of the present invention to provide a two-dimensional photonic crystal surface-emitting laser which emits single-lobed linearly polarized light and which has a high Q-value.

This object is achieved by a two-dimensional crystal surface-emitting laser according to claim 1 or 2.

In order to attain the object, a first aspect of the present invention provides a two-dimensional photonic crystal surface-emitting laser comprising a photonic crystal which has a photonic crystal periodic structure located in or near an active layer which emits light when carriers are injected thereto, the photonic crystal periodic structure having media with different refractive indices in two-dimensional periodic array, and the photonic crystal periodic structure is of a square lattice structure or a rectangular lattice structure which is classified into pg by a classification method under IUC (International Union of Crystallography in 1952).

In the two-dimensional photonic crystal surface-emitting laser according to the first aspect of the present invention, the photonic crystal has a photonic crystal periodic structure which is of a lattice structure classified into pg according to the two-dimensional pattern classification method. Thereby, the light emitted from a surface of the laser is single-lobed linearly polarized light which has a high Q value (a low threshold).

In the two-dimensional photonic crystal surface-emitting laser according to a second aspect of the present invention, it is preferred that the lattice structure of the photonic crystal has substantially triangular lattice points and that said photonic crystal periodic structure in classified into pm, cm or pl by a classification method under IUC.

### [Brief Description of the Drawings]

Fig. 1 is a plan view which shows an exemplary crystal surface (having triangular lattice points) of a two-dimensional photonic crystal surface-emitting laser according to the present invention.

Fig. 2 is a chart which shows electric field distribution of a surface-emitting component (mode I") of the photonic crystal shown by Fig. 1.

Fig. 3 is a chart which shows electric field distribution of a surface-emitting component (mode II") of the photonic crystal shown by Fig. 1.

Fig. 4 is a chart which shows electric field distribution of a surface-emitting component (mode III") of the photonic crystal shown by Fig. 1.

Fig. 5 is a chart which shows electric field distribution of a surface-emitting component (mode IV") of the photonic crystal shown by Fig. 1.

Figs. 6a, 6b and 6c are charts which show electric field distribution in mode I when a two-dimensional photonic crystal surface-emitting laser has circular lattice points.

Figs. 7a, 7b and 7c are charts which show electric field distribution in mode I' when a two-dimensional photonic crystal surface-emitting laser has elliptic lattice points.

Figs. 8a, 8b and 8c are charts which show electric field distribution in mode I" when a two-dimensional photonic crystal surface-emitting laser has triangular lattice points.

Figs. 9a and 9b are charts which show electric field distribution in mode I when a two-dimensional photonic crystal surface-emitting laser has circular lattice points, Fig. 9a showing the photonic crystal area and Fig. 9b showing a surface-emitted component.

Figs. 10a and 10b are charts which show electric field distribution in mode I" when a two-dimensional photonic crystal surface-emitting laser has triangular lattice points, Fig. 10a showing the photonic crystal area and Fig. 10b showing a surface-emitted component.

Fig. 11a, 11b and 11c are charts which show electric field distribution in mode II when a two-dimensional photonic crystal surface-emitting laser has circular lattice points.

Figs. 12a, 12b and 12c are charts which show electric field distribution in mode II' when a two-dimensional photonic crystal surface-emitting laser has elliptic lattice points.

Figs. 13a, 13b and 13c are charts which show electric field distribution in mode II" when a two-dimensional photonic crystal surface-emitting laser has triangular lattice points.

Figs. 14a and 14b are illustrations showing reflection and shear reflection respectively.

Fig. 15 is a plan view showing another exemplary lattice point shape and an exemplary arrangement pattern of lattice points.

Fig. 16 is a plan view showing another exemplary lattice point shape and an exemplary arrangement pattern of lattice points.

Fig. 17 is a plan view showing another exemplary lattice point shape and an exemplary arrangement pattern of lattice points.

Fig. 18 is a plan view showing another exemplary lattice point shape and an exemplary arrangement pattern of lattice points.

Fig. 19 is a plan view showing another exemplary lattice point shape and an exemplary arrangement pattern of lattice points.

Fig. 20 is a plan view showing another exemplary lattice point shape and an exemplary arrangement pattern of lattice points.

Fig. 21 is a plan view showing another exemplary lattice point shape and an exemplary arrangement pattern of lattice points.

Fig. 22 is a plan view showing another exemplary lattice point shape and an exemplary arrangement pattern of lattice points.

Fig. 23 is a plan view showing another exemplary lattice point shape and an exemplary arrangement pattern of lattice points.

Fig. 24 is a plan view showing another exemplary lattice point shape and an exemplary arrangement pattern of lattice points.

Fig. 25, is a perspective view of a two-dimensional photonic crystal surface-emitting laser of prior art.

Fig. 26 is an illustration showing resonation occurring in the two-dimensional photonic crystal surface-emitting laser.

Fig. 27 is a band chart showing scattering of light in a two-dimensional square lattice photonic crystal having true circular lattice points.

Fig. 28 is a band chart showing an area around a point S in Fig. 27.

Fig. 29 is a chart showing electric field distribution of surface-emitted components in mode I when a two-dimensional photonic crystal surface-emitting laser has true circular lattice points.

Fig. 30 is a chart showing electric field distribution in mode II when a two-dimensional photonic crystal surface-emitting laser has true circular lattice points.

Fig. 31 is a band chart showing scattering of light in a two-dimensional square lattice photonic crystal having elliptic lattice points.

Figs. 32a and 32b are charts showing electric field distribution in mode I' when a two-dimensional photonic crystal surface-emitting laser has elliptic lattice points, Fig. 32a showing electric field distribution of surface-emitted components and Fig. 32b showing electric field distribution in a photonic crystal.

Fig. 33 is a chart showing electric field distribution of surface-emitted components in mode II' when a two-dimensional photonic crystal surface-emitting laser has elliptic lattice points.

Fig. 34 is a chart showing electric field distribution of surface-emitted components in mode III' when a two-dimensional photonic crystal surface-emitting laser has elliptic lattice points.

Figs. 35a and 35b are charts showing electric field distribution in mode IV' when a two-dimensional photonic crystal surface-emitting laser has elliptic lattice points, Fig. 35a showing electric field distribution of surface-emitted components and Fig. 35b showing electric field distribution in a photonic crystal.

### [Best Modes for Carrying out the Invention]

Preferred embodiments of a two-dimensional photonic crystal surface-emitting laser according to the present invention are hereinafter described with reference to the accompanying drawings.

### Triangular Lattice Points

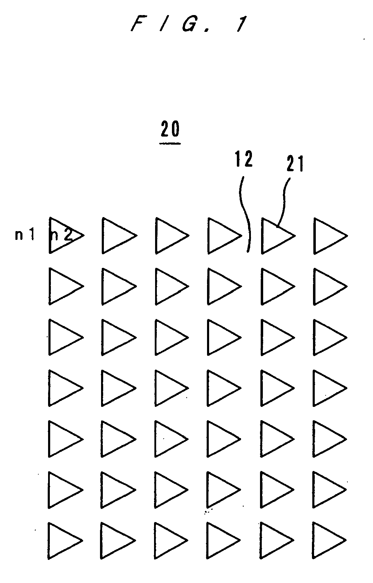

A two-dimensional photonic crystal surface-emitting laser according to the present invention, of which surface is shown by Fig. 1, is a two-dimensional photonic crystal 20, wherein in a first medium (a lower clad layer) 12 with a refractive index n1, points of a second medium 21 are arranged in a square lattice, so that a photonic crystal periodic structure composed of lattice points is formed. This fundamental structure of the two-dimensional photonic crystal surface-emitting laser according to the present invention is same as that of the conventional surface-emitting laser shown by Fig. 25, and the two-dimensional photonic crystal surface-emitting laser according to the present invention performs surface emission under the principle shown by Fig. 26.

The two-dimensional photonic crystal 20 shown by Fig. 1 has a square lattice structure composed of triangular lattice points 21, and the a square lattice structure has translation symmetry but does not have rotation symmetry.

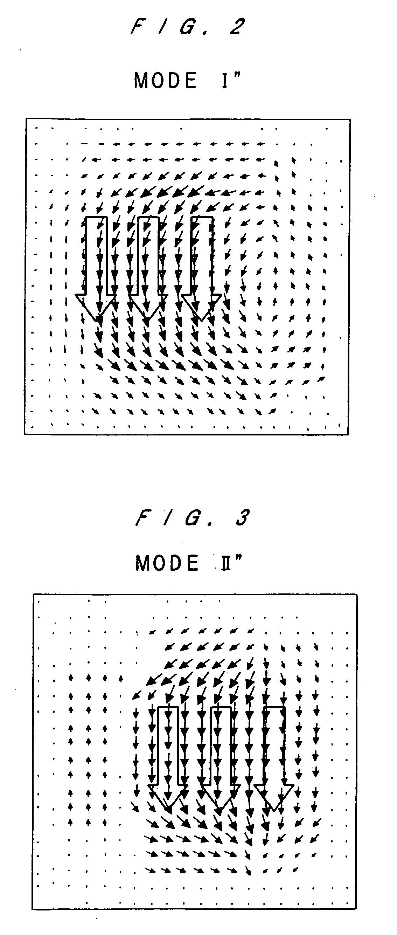

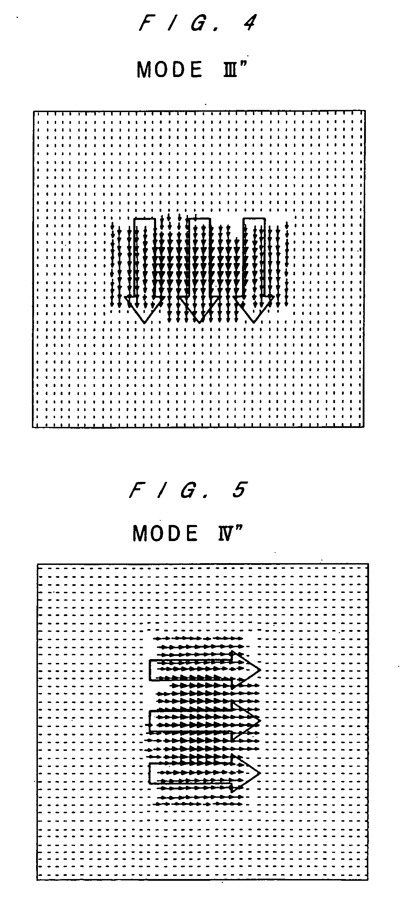

Figs. 2 through 5 show electric field distribution of a surface-emitted component when each of the lattice points 21 is triangular. In the two-dimensional photonic crystal 20, there are four modes I", II", III" and IV". As is apparent from Figs. 2 through 5, in all of the modes I", II", III" and IV", oscillation of single-lobed linearly polarized light can be achieved.

The modes I", II", III" and IV" are similar to the modes I', II', III' and IV' wherein each of the lattice points is elliptic (see Figs. 32a through 35b), respectively. The modes I" and II" have advantages over the modes III" and IV" in that the Q-value of the resonator is higher and in that the threshold is lower. In other words, in the modes I" and II", both a low threshold and single-lobed beam can be achieved. Therefore, a two-dimensional photonic crystal 20 with triangular lattice points uses the modes I" and II" as oscillation modes.

The above-described phenomenon is understood as follows. A two-dimensional photonic crystal is a laser which emits light in a direction perpendicular to an emission surface. The photonic crystal has a periodically changing refractive index, and the polarization of light depends on the direction of electric field in areas with a lower refractive index. When the lattice points are elliptic, for example, in the mode I', as shown in Fig. 32b, and electric field to right and an electric field to left exist respectively in the upper side and in the lower side of a line of elliptic lattice points with a lower refractive index. Thereby, the light is taken out of the photonic crystal by diffraction, and after interference, as shown by Fig. 32a, an electric field distribution with an upper electric fields and a lower electric field with mutually different phases is obtained.

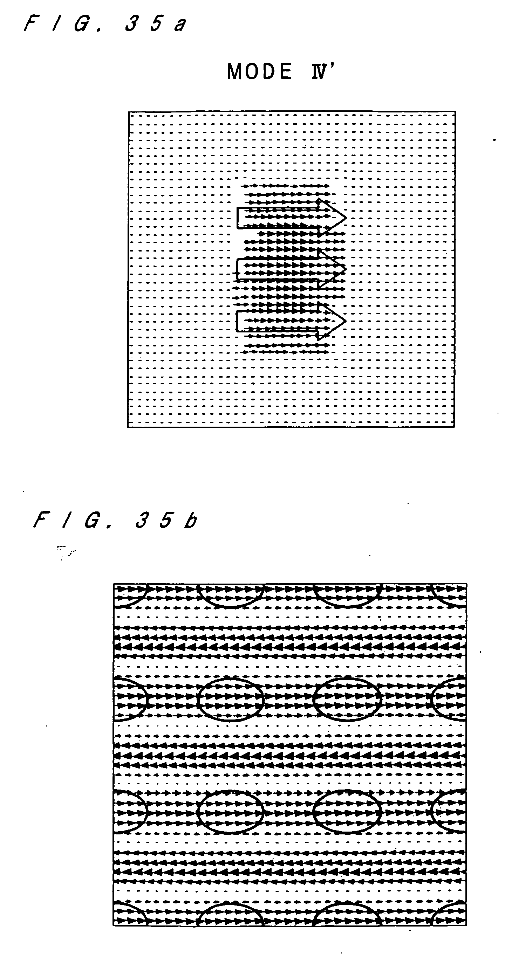

On the other hand, for example, in the mode IV', as shown in Fig. 35b, an electric field in one direction extends over a line of elliptic lattice points. The light is taken out of the photonic crystal by diffraction, and after interference, an electric field distribution with electric fields in one direction can be obtained as shown by Fig. 35a.

Thus, in order to achieve an oscillation mode with an electric field distribution with linear polarization and single-lobe, an electric field distribution with electric fields in one direction extending over the areas of the second medium with a lower refractive index is formed.

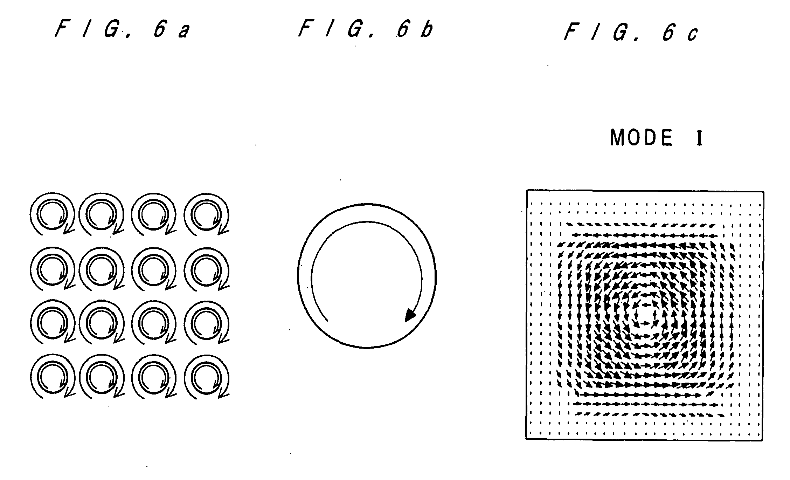

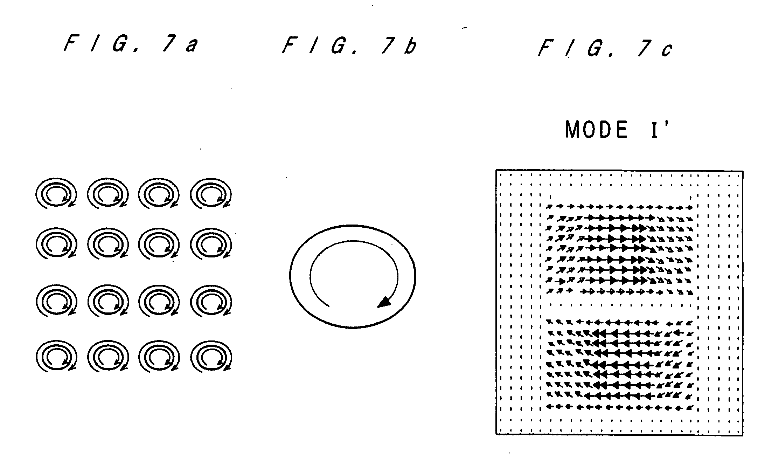

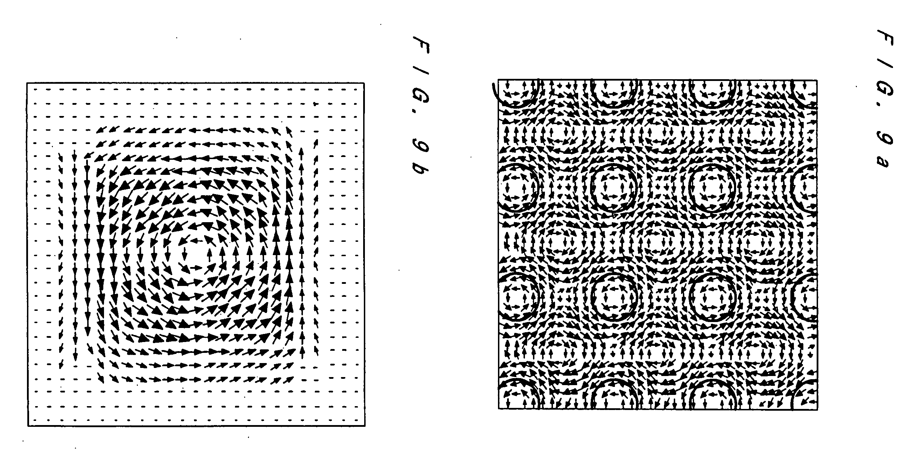

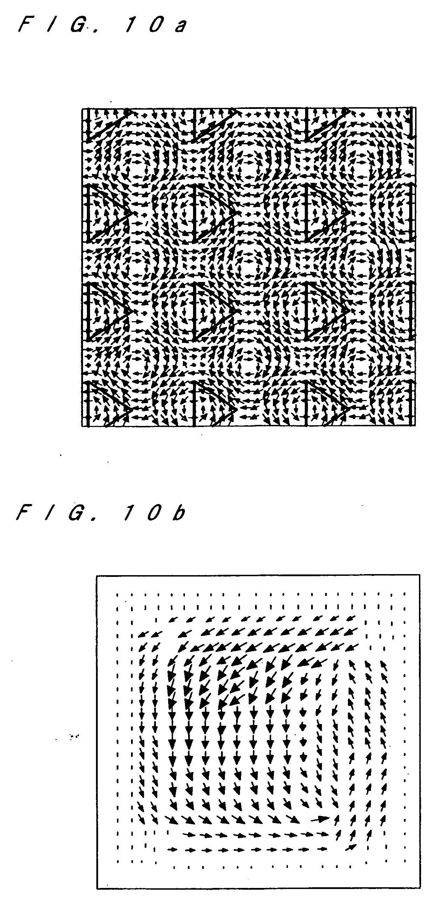

Figs. 6a to 6c, 7a to 7c and 8a to 8c schematically show electric field distributions in the modes I, I' and I" when the lattice points are true circular, elliptic and triangular, respectively. Each of Figs. 6a, 7a 8a shows an electric field distribution inside the photonic crystal. Each of Figs. 6b, 7b and 8b shows an electric field distribution in one cycle (around a lattice point) of the two-dimensional photonic crystal periodic structure of the second medium with a low refractive index. Each of Figs. 6c, 7c and 8c shows an electric distribution of components which are taken out in a direction perpendicular to the emitting surface. Figs., 9a, 9b, 10a and 10b show more detailed electric field distributions. Figs. 9a and 9b show a case wherein the lattice points are true circular, and Figs. 10a and 10b show a case wherein the lattice points are triangular.

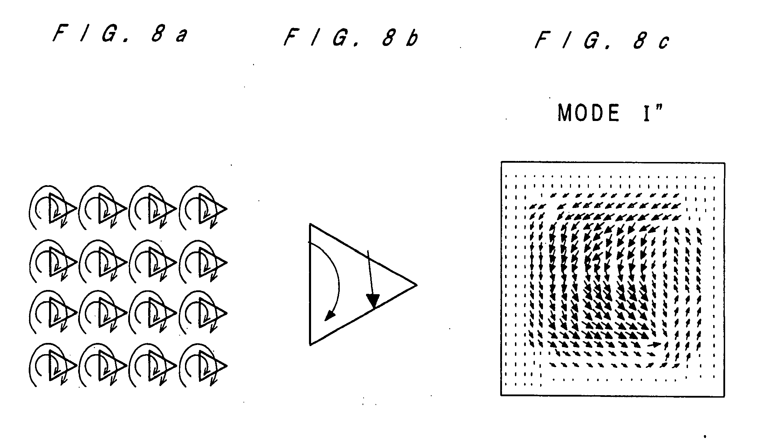

When the lattice points are triangular, the electric field distribution of components which are taken out in the direction perpendicular to the emitting surface, as shown in Figs. 8a, 8b and 8c, is a pattern rotated by 180 degrees from the electric field distribution in the two-dimensional photonic crystal periodic structure of the second medium with a low refractive index.

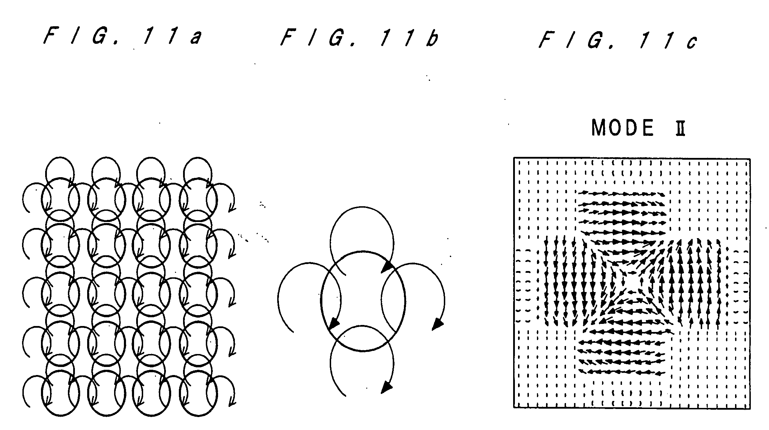

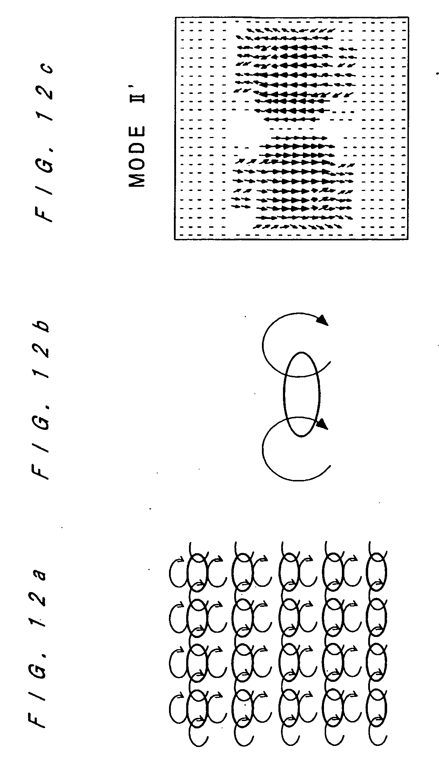

In the same way as Figs. 6a to 6c, 7a to 7c and 8a to 8c show electric field distributions in the modes I, I' and I", Figs. 11a to 11c, 12a to 12c and 13a to 13c schematically show electric field distributions in the modes II, II' and II" when the lattice points are true circular, elliptic and triangular, respectively.

### Conditions and Kinds of Lattice Points

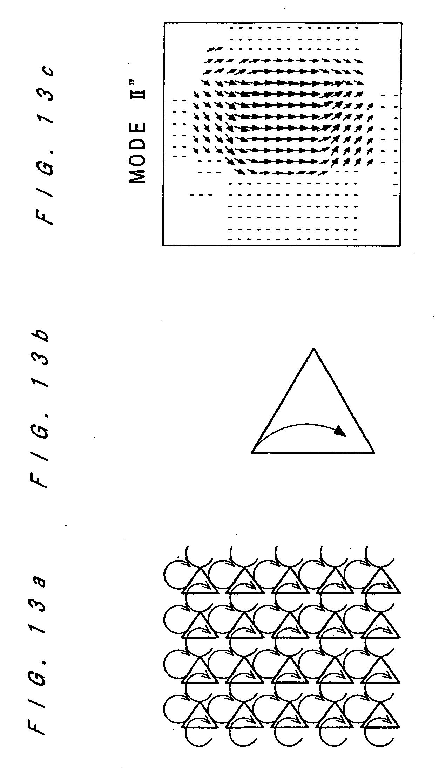

As is apparent from Figs. 8a, 8b, 8c, 13a, 13b and 13c, the essential purpose for forming triangular lattice points is lagging the refractive index period and the electric field distribution period from each other. This purpose can be achieved not only when the lattice points are triangular but also when the lattice structure forming the two-dimensional photonic crystal satisfies the following conditions.

The lattice structure shall be of a square lattice or a rectangular lattice, which does not have rotational symmetry. It is generally known that two-dimensional periodical patterns are classified into 17 kinds under IUC (International Union of Crystallography in 1952). These 17 kinds are p1, pm, pg, cm, p2, pmm, pgg, cmm, pmg, p4, p4m, p4g, p3, p31m, p3ml, p6 and p6m. As shown in Table 1 below, of these 17 kinds, those which do not have rotational symmetry are p1, pm, pg and cm. The lattice structure with triangular lattice points corresponds to pm.

**Table 1**

| ICU Marks | Conditions | Possible Lattice Structure |
|---|---|---|
| pl | not including reflection and shear reflection | oblique lattice, rectangular lattice, face-centered lattice, square lattice, hexagonal lattice |
| pm | including reflection The axis of shear reflection is also the axis of reflection. | rectangular lattice, square lattice |
| pg | not including reflection and including shear reflection | rectangular lattice, square lattice |
| cm | including reflection There is an axis of shear reflection which is not an axis of reflection. | face-centered lattice, square lattice, hexagonal lattice |

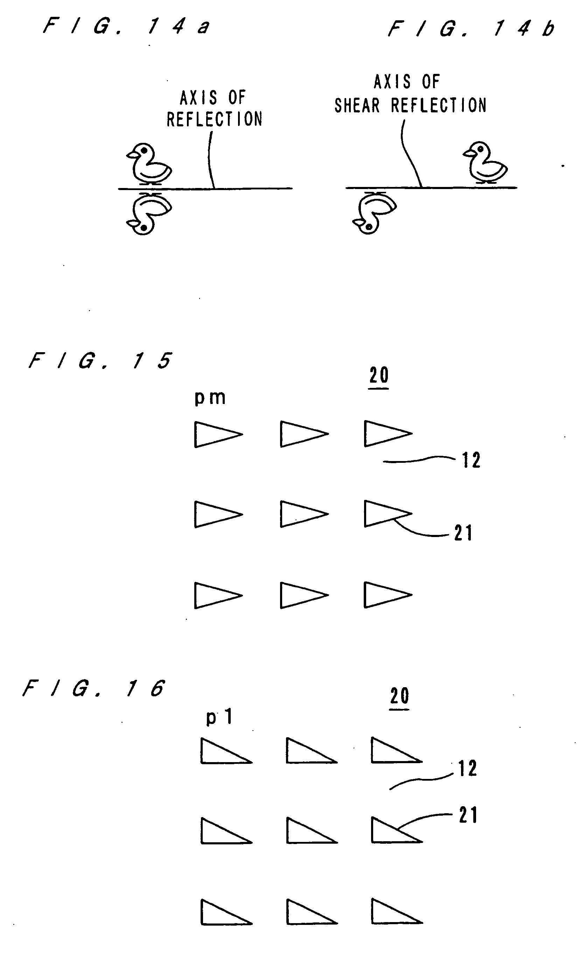

Reflection is a pattern which is line symmetrical on an axis of reflection as shown in Fig. 14a. Shear reflection is a pattern shifted along an axis of shear reflection from a reflection as shown in Fig. 14b.

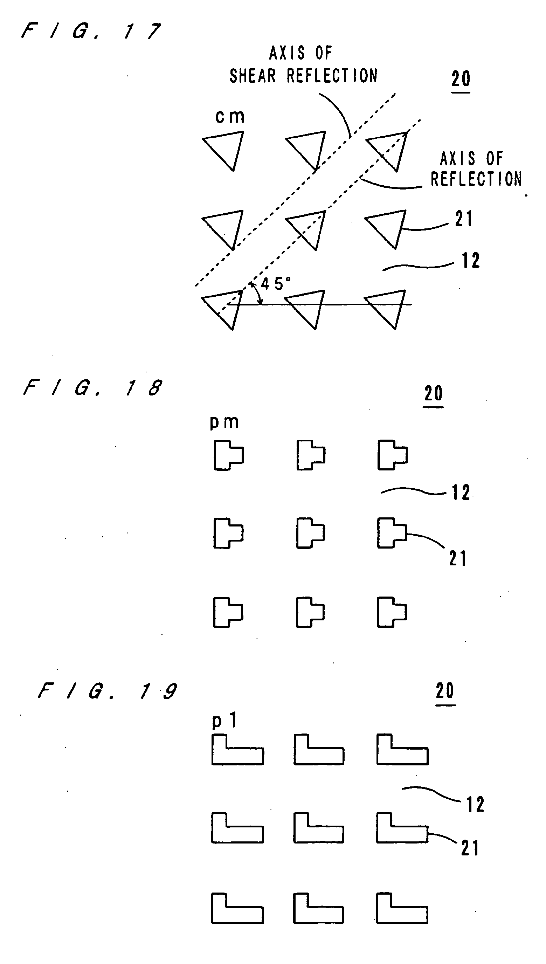

Possible shapes of lattice points and possible patterns (p1, pm, pg, cm) are shown in Figs. 15 through 24. In Figs. 15 through 21, the corners of the respective lattice points are illustrated to be 90 degrees or less. In actually fabricated periodical structures, however, these corners are rounded-off.

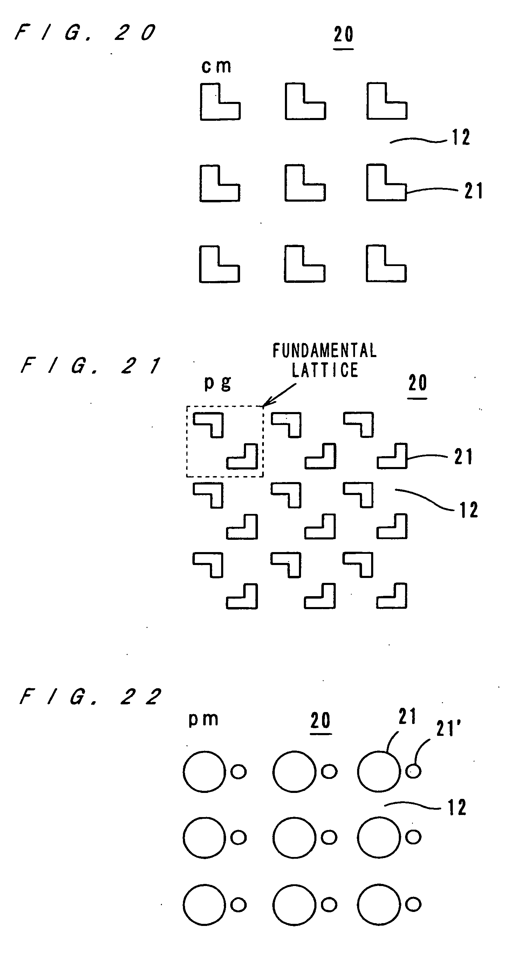

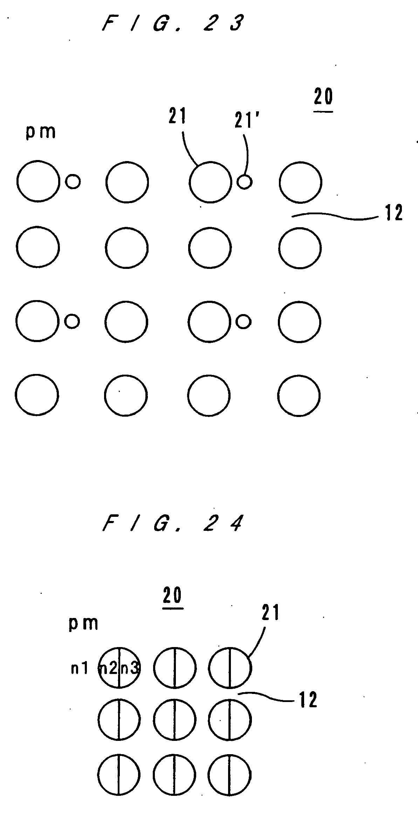

As Figs. 22 and 23 show, a lattice structure with translation symmetry but without rotation symmetry can be formed only by adding a small circle 21' to each circular lattice point 21 without changing the shape of each lattice point. Also, it is sufficient to add one small circle to several lattice periods. To sum up, in the lattice structure, as a whole, a fundamental lattice of a finite size shall be defined, and the defined fundamental lattice, such as a square lattice or a rectangular lattice, shall be repeated.

Also, as Fig. 24 shows, although the shape of each lattice point is true circular, a lattice structure with a pattern corresponding to pm can be achieved by providing a third medium with a third refractive index n3 to each of the lattice points. More specifically, after making hollow holes in the first medium, the second medium with a refractive index n2 and the third medium with a refractive index n3 are filled in each of the hollow holes. It is possible to use air as the second medium with the refractive index n2, and in this case, the third medium with the refractive index n3 is filled in a semicircle of each of the hollow holes. Alternatively, a medium with a distribution of two or more different refractive indices may be filled in each of the hollow holes.

### Other Embodiments

Although the present invention has been described in connection with the preferred embodiments above, it is to be noted that various changes and modifications are possible to those who are skilled in the art. Such changes and modifications are to be understood as being within the scope of the present invention.

The materials of the semiconductor layer, the photonic crystal and the electrodes may be selected arbitrarily, and the structure for achieving uniform polarization direction may be designed arbitrarily. Also, the photonic crystal periodic structure is not necessarily formed in the lower clad layer and may be provided in or near the active layer of the upper clad layer.

In the above-described embodiments, the refractive index of the second medium is lower than that of the first medium. However, the refractive index of the second medium may be higher than that of the first medium.

## Claims

1. A two-dimensional photonic crystal surface-emitting laser (10) comprising:
a photonic crystal (20) which has a photonic crystal periodic structure located in or near an active layer (13) which emits light when carriers are injected thereto,
said photonic crystal periodic structure having media with different refractive indices (n1, n2; n1, n2, n3) in two-dimensional periodic array, and
said photonic crystal periodic structure being of a square lattice structure or a rectangular lattice structure,
**characterized in that**
said photonic crystal periodic structure is classified into the plane symmetry group pg by a classification method under International Union of Crystallography in 1952.

2. A two-dimensional photonic crystal surface-emitting laser (10) comprising:
a photonic crystal (20) which has a photonic crystal periodic structure located in or near an active layer (13) which emits light when carriers are injected thereto,
said photonic crystal periodic structure having media with different refractive indices (n1, n2; n1, n2, n3) in two-dimensional periodic array, and
said photonic crystal periodic structure being of a square lattice structure or a rectangular lattice structure,
**characterized in that**
the photonic crystal (20) comprises substantially triangular lattice points (21), and
said photonic crystal periodic structure is classified into one of the plane symmetry groups pm, cm or pl by a classification method under International Union of Crystallography in 1952.

## Patentansprüche

1. Ein oberflächenemittierender Zweidimensionaler-Photonischer-Kristall-Laser (10), der folgende Merkmale aufweist:
einen photonischen Kristall (20), der eine Photonischer-Kristall-Periodenstruktur aufweist, die sich in oder nahe einer aktiven Schicht (13) befindet, die Licht emittiert, wenn Träger in dieselbe injiziert sind,
wobei die Photonischer-Kristall-Periodenstruktur Medien mit unterschiedlichen Brechungsindizes (n1, n2; n1, n2, n3) in einem zweidimensionalen periodischen Array aufweist und
die Photonischer-Kristall-Periodenstruktur von einer Quadratgitterstruktur oder einer rechteckigen Gitterstruktur ist,
**gekennzeichnet dadurch, dass**
die Photonischer-Kristall-Periodenstruktur in die Ebene-Symmetriegruppe pg klassifiziert ist, durch ein Klassifizierungsverfahren unter der International Union of Crystallography 1952.

2. Ein oberflächenemittierender Zweidimensionaler-Photonischer-Kristall-Laser (10), der folgende Merkmale aufweist:
einen photonischen Kristall (20), der eine Photonischer-Kristall-Periodenstruktur aufweist, die sich in oder nahe einer aktiven Schicht (13) befindet, die Licht emittiert, wenn Träger in dieselbe injiziert sind,
wobei die Photonischer-Kristall-Periodenstruktur Medien mit unterschiedlichen Brechungsindizes (n1, n2; n1, n2, n3) in einem zweidimensionalen periodischen Array aufweist und
wobei die Photonischer-Kristall-Periodenstruktur von einer Quadratgitterstruktur oder einer rechteckigen Gitterstruktur ist,
**dadurch gekennzeichnet, dass**
der photonische Kristall (20) im Wesentlichen Dreieckgitterpunkte (21) aufweist und
die Photonischer-Kristall-Periodenstruktur in eine der Ebene-Symmetriegruppen pm, cm oder pl klassifiziert ist, durch ein Klassifizierungsverfahren unter der International Union of Crystallography 1952.

## Revendications

1. Laser à émission par la surface à cristal photonique bidimensionnel (10) comprenant:
un cristal photonique (20) qui présente une structure périodique de cristal photonique située dans ou près d'une couche active (13) qui émet de la lumière lorsque des porteuses y sont injectées,
ladite structure périodique de cristal photonique présentant des supports à indices de réfraction différents (n1, n2; n1, n2, n3) en réseau périodique bidimensionnel, et
ladite structure périodique de cristal photonique étant une structure réticulaire carrée ou une structure réticulaire rectangulaire,
**caractérisé par le fait que**
ladite structure périodique de cristal photonique est classifiée en groupe de symétrie dans le plan pg par une méthode de classification selon l'Union Internationale de Cristallographie en 1952.

2. Laser à émission par la surface à cristal photonique bidimensionnel (10) comprenant:
un cristal photonique (20) qui présente une structure périodique de cristal photonique située dans ou près d'une couche active (13) qui émet de la lumière lorsque des porteuses y sont injectées,
ladite structure périodique de cristal photonique présentant des supports à indices de réfraction différents (n1, n2; n1, n2, n3) en réseau périodique bidimensionnel, et
ladite structure périodique de cristal photonique étant une structure réticulaire carrée ou une structure réticulaire rectangulaire,
**caractérisé par le fait que**
le cristal photonique (20) comprend substantiellement des points réticulaires triangulaires (21), et
ladite structure périodique de cristal photonique est classifié en l'un des groupes de symétrie dans le plan pm, cm ou pi par une méthode de classification selon l'Union Internationale de Cristallographie en 1952.
